Europäisches Patentamt

European Patent Office

Office européen des brevets

(19)

(11) Publication number: **0 185 978**

**A2**

(12) **EUROPEAN PATENT APPLICATION**

(21) Application number: 85115320.5

(51) Int. Cl.⁴: **G11C 11/40**

(22) Date of filing: 03.12.85

(30) Priority: 17.12.84 US 682391

(43) Date of publication of application:
02.07.86 Bulletin 86/27

(84) Designated Contracting States:
DE FR GB

(71) Applicant: International Business Machines Corporation
Old Orchard Road
Armonk, N.Y. 10504(US)

(72) Inventor: Jordy, George John
Rd 3, Smith Crossing Road
Wappingers Falls New York(US)
Inventor: Mosley, Joseph M.
1 Gene Court
Hopewell Junction New York 12533(US)

(74) Representative: Rudolph, Wolfgang, Dipl.-Ing.
Schönaicher Strasse 220
D-7030 Böblingen(DE)

(54) Random access memory.

(57) In an integrated circuit a random access read/write memory array, said memory array with m pairs of bit lines, each pair of bit lines including a first bit line and a second bit line; n pairs of word-drain lines, each pair of word-drain lines including a word line and a drain line; each of said m columns of memory cells being connected between the first bit line and the second bit line of a discret one of said m pairs of bit lines; each of said n rows of memory cells being connected between the word line and drain line of a discrete one of said n pairs of word-drain lines; controllable read/write address decoder circuit means for reading the binary bit ("0" or "1") stored in any predetermined one of said m x n array of memory cells, or writing a binary bit ("0" or "1") in any predetermined one said m x n array of memory cells; and with n identical write enhancement circuit means for enhancing the operation of said random access read/write memory, each of said n identical write enhancement circuit means being a two-terminal device and each of said n identical circuit means being connected between the word line and the drain of a discrete one of said n pairs of word-drain lines.

FIG. 5

FIG. 5A

0 185 978

FIG. 5 | FIG. 5A | FIG. 5B

FIG. 5

SENSE AMPLIFIER / LATCH

SR

BIT DECODER m

WRITE CIRCUIT m

WRITE 0   WRITE 1

WRITE ENABLE

WORD LINE 1

DRAIN LINE 1

LEFT BIT m        RIGHT BIT m

WORD LINE n

DRAIN LINE n

3

Random Access Memory

The invention relates to an improved integrated random access read/write memory array as defined in the preamble of claim 1.

With the emergence of VLSI through the advances of integrated circuit technology, denser random access memory (RAM) array chips with high-speed access times are an absolute requirement in computing machine designs. As the industry strives for higher and higher computing speeds, measured in millions of instructions per second (MIPS), the time required to complete each instruction must be decreased. By increasing array densities, the number of array chips required to perform a specific function is reduced and therefore the overall function delay. The invention disclosed and claimed herein is an improved random access memory (RAM) which positively addresses the requirements of speed, size (area), stability and alpha particle sensitivity.

The complementary transistor switch (CTS) memory cell is well known to the art. See for example: (1) U. S. Patent No. 3863229 entitled "SCR (or SCS) Memory Array With Internal and External Load Resistors", granted January 28, 1975 to J. E. Gerbach and of common assignee with the subject application; (2) "AC Write Scheme For Bipolar Random-Access Memories Using Schottky Coupled Cells" by J. A. Dorler et al, IBM TDB Vol. 23, No. 11, April 1981; or, (3) "A 1024-Byte ECL Random Access Memory Using a Complementary Transistor Switch (CTS) Cell" by J. A. Dorler et al, IBM Journal of Research and Development, Vol. 25, No. 3, May 1981 pages 126-134.

The unclamped complementary transistor switch (CTS) type memory cell is disclosed in the publication "Saturated CTS Memory Cell Using A PNP Load" by J. A. Dorler et al, IBM TDB, February 1984, Vol. 26, No. 9, pages 4720-1.

Most present array cells are SBD protected against saturation. This was clearly needed when the number of cells was small, the transistors were large and the currents were large to accommodate high speed at high capacitances. This would have resulted in very long delays for cell saturation if not for the SBD clamps. However, now with better processes and improved lithography, the saturation capacitance of the cell can be equal to or less than the metal line capacitance of the array. With the advent of improved circuit designs and very low standby currents (typically $\leq 5$ µA) the SBD's are no longer required. What is being disclosed here is the removing of the clamp SBD from the array cells.

In summary, removing the SBD diodes will enable future arrays to be:

```
more dense     (w)  32.6X44.5um    (w/o)  32.6X41.0um

more stable    (w)  426mv @.1pf    (w/o)  642mv @2.0pf

less power     (w)  5 ua @.821v    (w/o)  1ua @.609v
```

These comparisons were made using the same layout groundrules and photolithography restrictions that are representative of current technology. It can be appreciated that even more benefit can be achieved with future lithography improvements.

The unclamped CTS cell has a long write time because of high stability. The use of a shunt to fix the word to drain line voltage is of great benefit to the stabilization of cell current and therefore saturation capacitance. It has been shown that it will improve the write time of the cell by a factor of eight.

The primary object of the invention is to provide an improved random access read/write memory array employing modified CTS type memory cells of small area, high stability, low power requirements, high reliability (fewer components), materially enhanced "write operation" time and relatively high immunity to "alpha particle errors".

The solution of the object is disclosed in the characterized part of claim 1. Improvements are characterized in Claims 2 - 6.

The concern over alpha particle sensitivity is fairly recent but a detailed explanation of bipolar RAM sensitivity to alpha particle bombardment can be found in the references set forth hereinafter. The modified CTS cell is at least an order of magnitude less sensitive to alpha particle errors than a comparable cell made with the same technology.

The foregoing and other objects, features and advantages of the invention will be more apparent from the following more particular descripton of the preferred embodiment of the invention, as illustrated in the accompanying drawings.

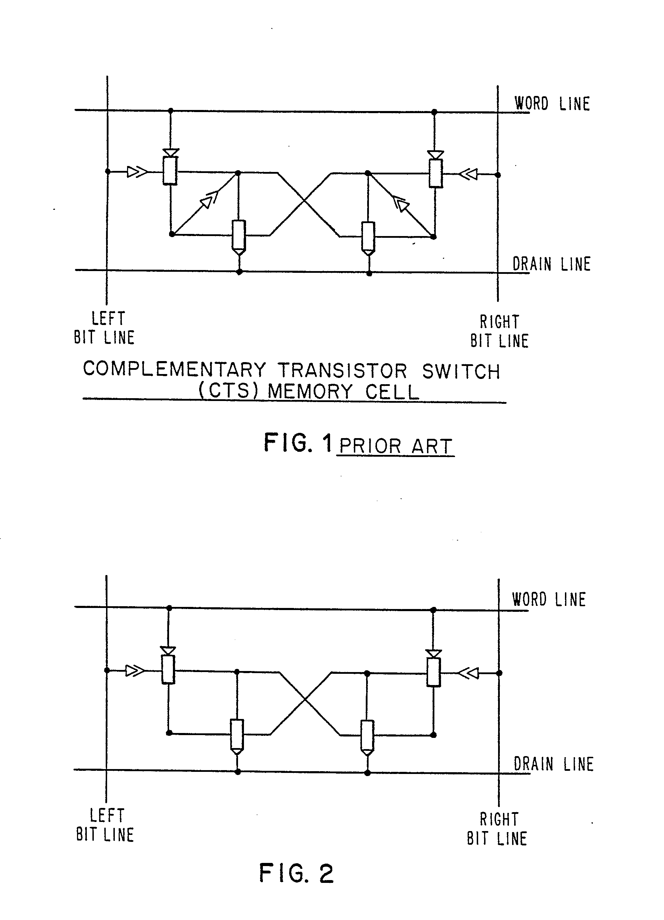

Figure 1 is a circuit diagram of the well known (prior art) complementary transistor switch (CTS) memory cell.

Figure 2 is a circuit diagram of an unclamped complementary transistor switch (CTS) type memory cell which is employed in the preferred embodiment of the improved random access memory in accordance with the invention.

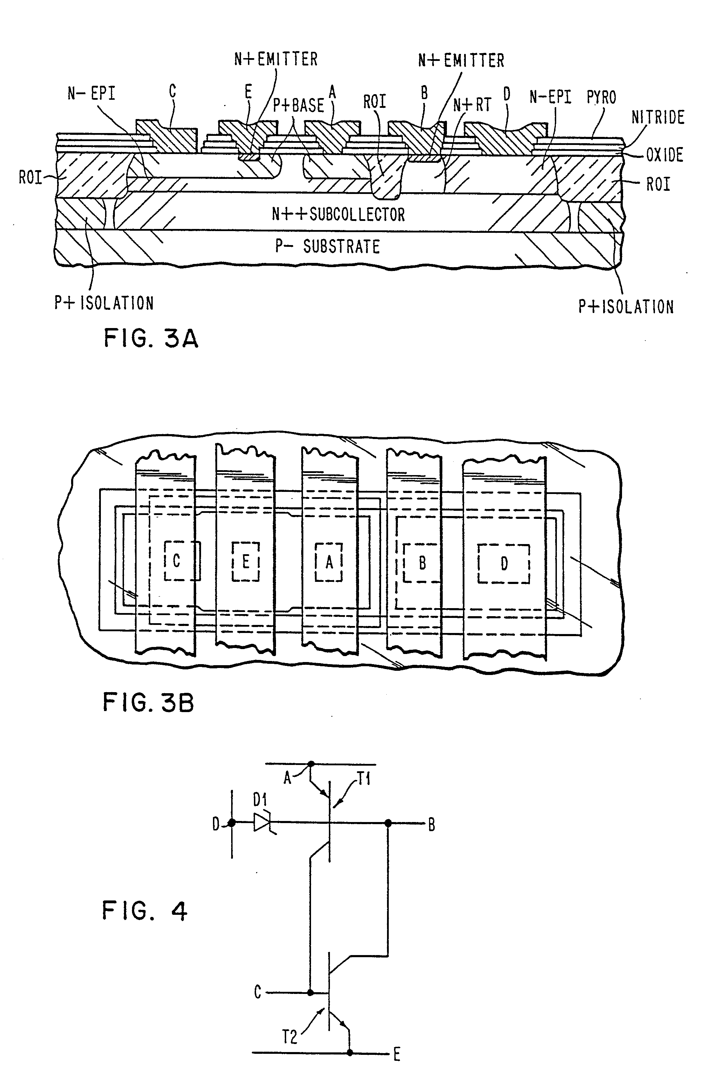

Figure 3 depicts a structural layout of a half portion of the unclamped complementary transistor switch (CTS) type memory cell of Figure 2.

Figure 4 is a circuit diagram corrresponding to the structural layout of the half portion of the unclamped complementary transistor swith (CTS) type memory cell of 3.

Figure 5 a composite of Figures 5A and 5B, is a block diagram of a random access read/write memory array in accordance with the invention.

Figure 5C discloses idealized waveforms illustration the "read operation" and the "write operation" of the random access memory array in accordance with the invention and are to be viewed in conjunction with Figure 5.

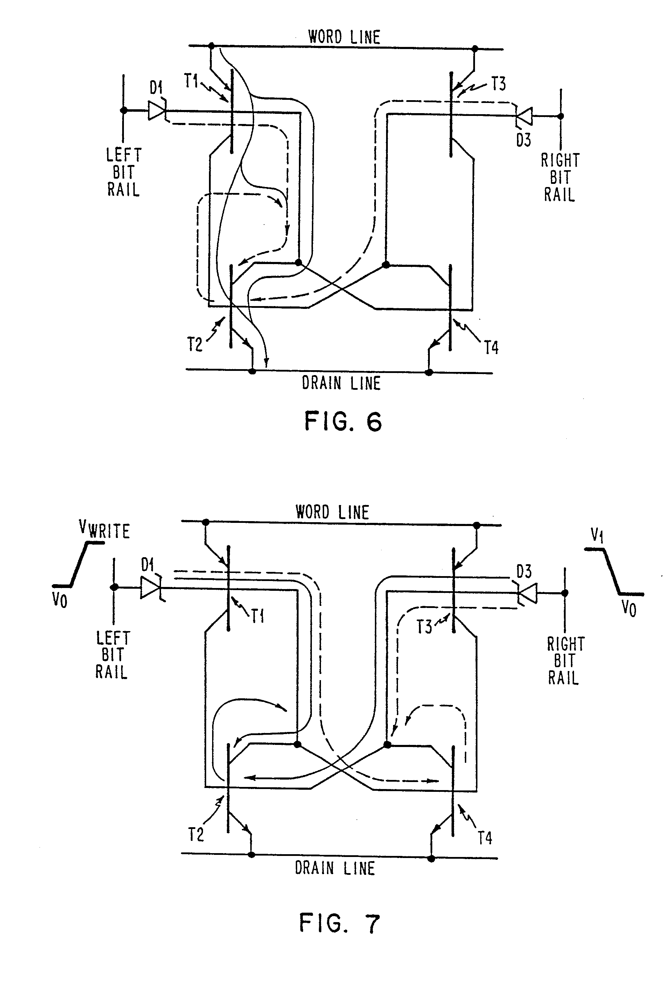

Figure 6 depicts the circuitry and current paths of the unclamped complementary transistor switch (CTS) type memory cell in a standby mode (solid lines for current flow) and in a "read mode", or "read operation" (dashed lines for current flow).

Figure 7 depicts the circuitry and current paths of the unclamped complementary transistor switch (CTS) type memory cell in a "write mode" or "write operation" (solid lines represent current flow for present state, dashed lines represent current flow for next state).

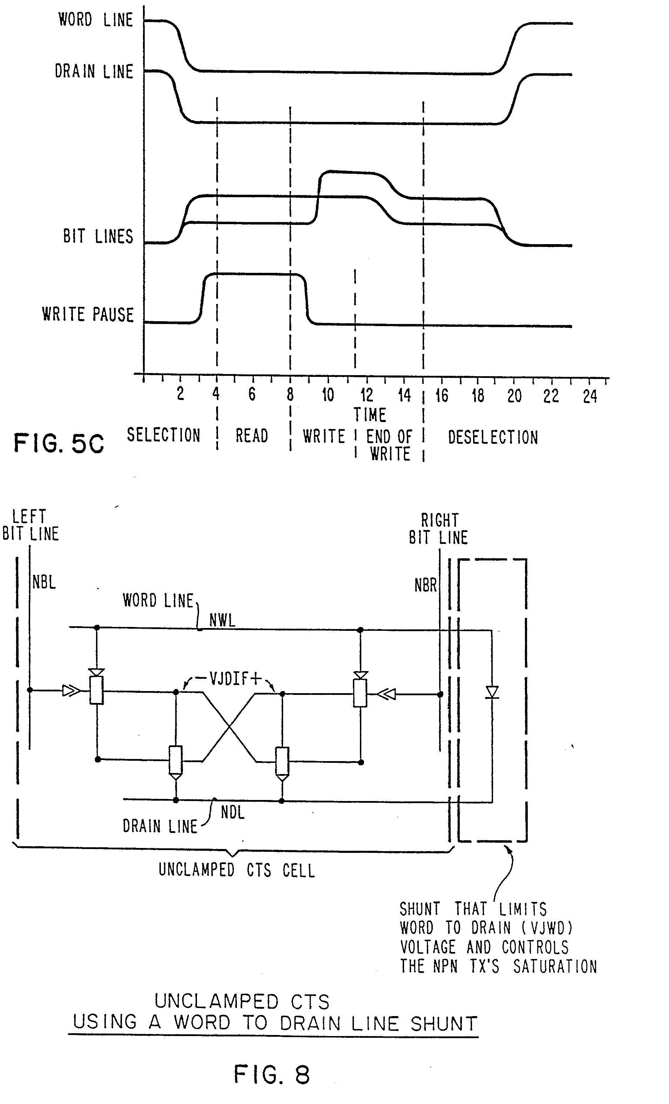

Figure 8 depicts a circuit diagram of an unclamped CTS type memory cell with a word line to drain line shunt.

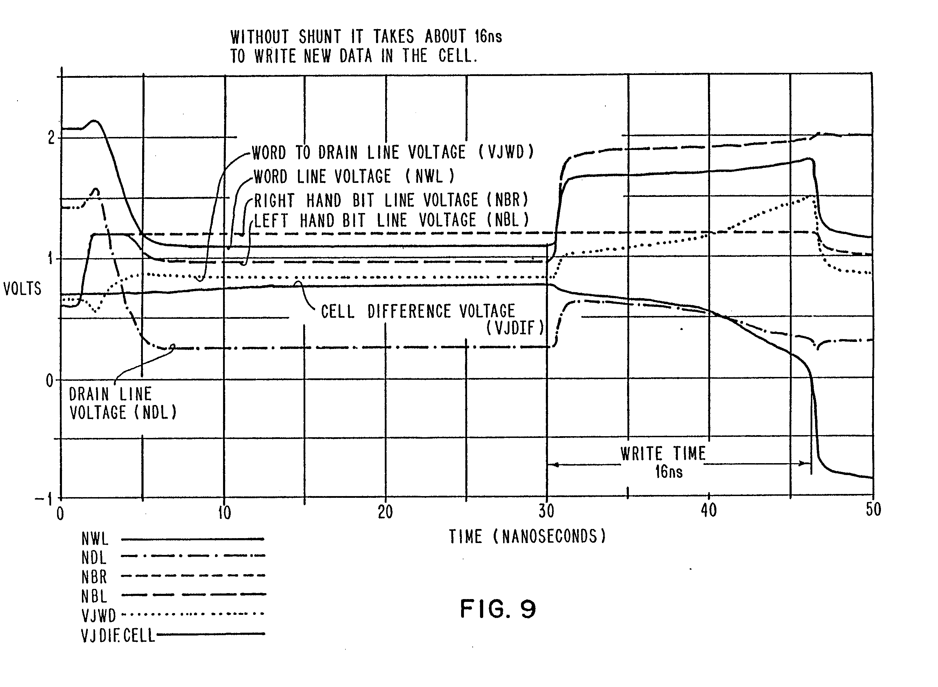

Figure 9 discloses idealized waveforms to be viewed in conjunction with the hereinafter explanation of the "write operation" of an unclamped CTS type memory cell in the absence of a word line to drain line shunt.

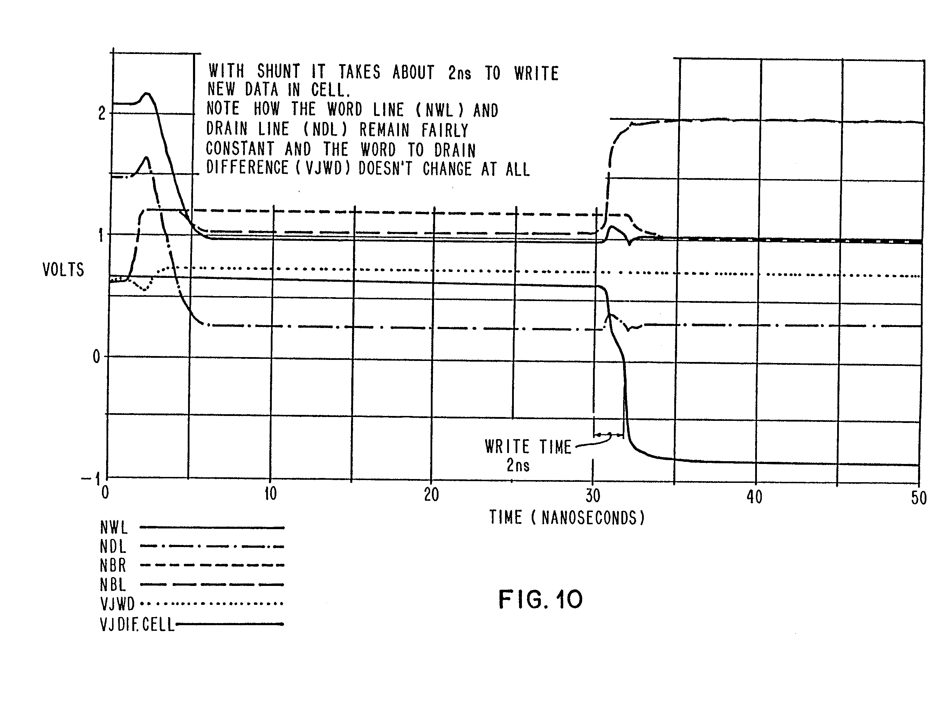

Figure 10 discloses idealized waveforms to be viewed in conjunction with the hereinafter explanation of the "write operation" of an unclamped CTS type memory cell in the presence of a word line to drain line shunt.

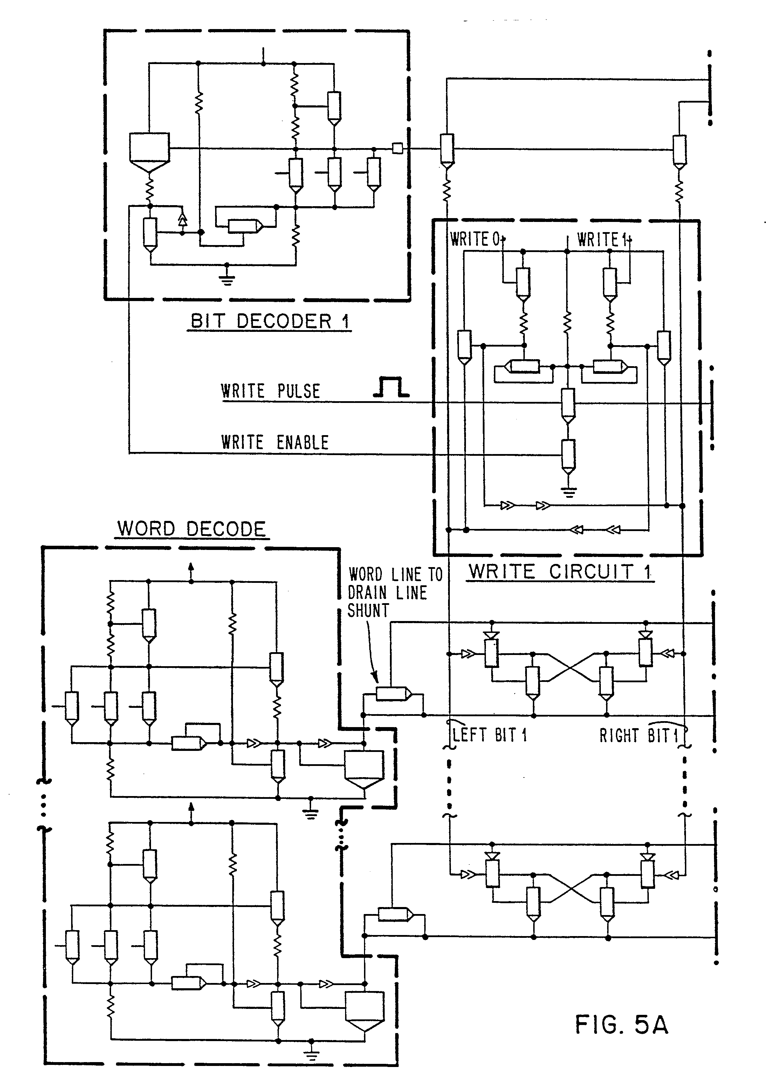

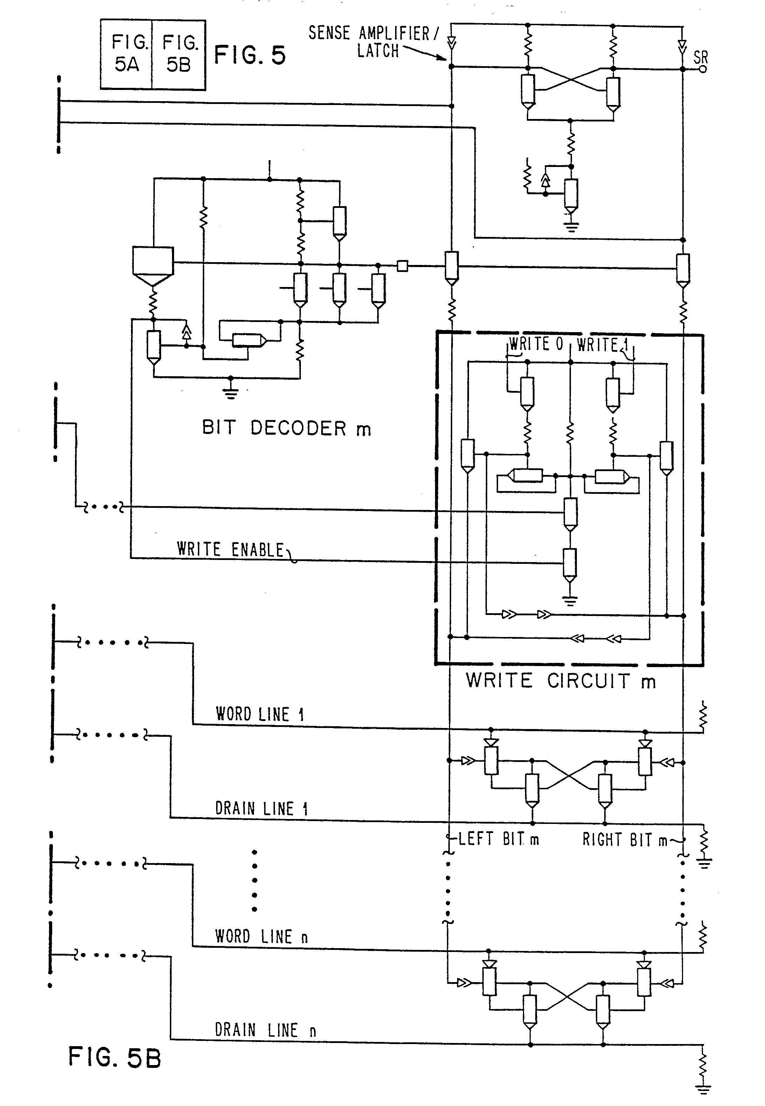

Refer to figure 5A, B and C for the preferred embodiment of the invention. In an array of memory cells comprised of M columns and N rows, a cell is selected by simultaneously raising the voltage on the pair of bit lines and lowering the voltage on the word and drain lines it is connected to. The method of lowering the voltage on the word and drain lines has almost exclusively been used to cause a higher current to flow through the memory cell and reinforce the state it is in. This method allows a faster read operation because the increased current flow is easier to sense. However in the case of the modified CTS cell, an increase in cell current is highly ditrimental to the ability to change the cells state when writing it.

The current through the modified CTS cell is exponentially related to the voltage from word line to drain line. The use of a word to drain line shunt, in this case is a simple PN diode, to fix the word to drain line difference is a tremendous aid in stabilizing the cell current even though the word and drain line voltage changes substantially during selection.

Refer to figure 5A, B and C during the following explanation of the read and write operation. For a cell to be read or written it must be in a fully selected state, cells in a half selected state are immune from read or write operations. A cell is selected in the word dimension by lowering the voltage on the word and drain line (WL and DL) it is connected to. A cell is selected in the bit dimension by raising the voltage on the bit lines (BL and BR) it is connected to. A cell that is connected to a selected pair of bit lines and selected word/drain lines is fully selected, and its content may be read or altered. Reading the content of a cell is accomplished by sensing a differential voltage or current in the bit lines. For example, if the cell contains a "0", which could be defined by transistor NPNL conducting, it could be read by the bit decode circuit raising the voltage of node BIT, and the word decode lowering the voltage of node DL. If NPNL was conducting then in fully selected state collector current would flow thru RBL and DL, the base current for NPNL is supplied thru RBR and DR. Transistor PNPL is slightly conducting while PNPR and NPNR are nonconducting. The differential current that flows in the bit lines is determined by the beta of the NPN transistor in the cell. Typically the beta value is 100 and the voltage difference between the bit lines or the differential current between TBSL and TBSR can easily be sensed.

When the bit decode selects the proper bit column to read, it also does one other thing; it enables the write circuit. If a pulse occurs on the WC line, which is connected to all write circuits, new data will be written into the selected cell. The W1 and W0 lines are always out of phase with each other, for the case of writing a "1" the W1 line would be high and W0 low. The cell is brought into the fully selected state by the word and bit decoders. The write circuit is enabled by raising the BS line. The writing is accomplished by a pulse on the WC line. When WC goes high current will flow thru RL and TCL because W1 is high and W0 is low. RL and RR regulate the amount of current thru TCL or TCR. When a PN junction is foward biased it is well known that it stores charge in its depletion layer. This charge is what is used to write the cell. When WC falls transistor TWC turns off. Node C will rise to the positive supply thru resistor RC. The charge that was stored in the base-collector junction of TCL gets coupled onto node L. The rise in voltage of node L turns on transistor TBL and raises the voltage of the left bit line BL above the right bit line BR. It should be noted that this technique will raise node L above the positive supply VC. The cell is written when the rising left bit line becomes high enough to turn on NPNR. At this point in time the current in the bit line switches from being the collector current of NPNL to base current of NPNR. The state change of the cell, from 0 to 1, corresponds to an impedance change seen on the bit line by TBL. Because BL is now in a high impedance state there is no good discharge path for node L. If this condition were to remain then the contents of the next selected cell in that bit column could be altered. To remedy that condition diodes D1 and D2 are connected from node L to the opposite bit line that was raised. At the time that BL changed from supplying the collector current of NPNL to supplying the base cutent of NPNR, BR changed from suppling base current of NPNL to collector current of NPNR. As the current in BR increases its voltage drops to the point where D1 and D2 conduct and discharge node L. The base and collector currents of NPNR are eventually supplied by transistors TBSL and TBSR respectively as the write circuit shuts itself off. This self limiting feature of the write circuit makes possible high speed write operation and very low power dissipation. It can be appreciated that the write circuit uses power only when the write pulse is high, typically a low duty cycle. At all other times and for all unselected bit columns the write circuit dissipates zero power.

Although the invention has been described with reference to a preferred embodiment, it is understood that the present disclosure has been made only by way of example and that numerous changes may be made without departing from the spirit and scope of the invention.

**Claims**

1. Integrated random access read/write memory, said solid state memory array including

at least first and second pairs of bit lines, each pair of bit lines including a left bit line and a right bit line;

at least first and second pairs of word-drain lines, each pair of word-drain lines including a word line and a drain line,

at least first, second, third and fourth complementary transistor current switch (CTS) type memory cells each being connected between said word line and said drain line of said first pair of word-drain lines and respectively between said first and second pairs of bit lines,

said third and fourth CTS type memory cells each being connected between said word line and said drain line of said second pair of word-drain lines and respectively between said first and second pairs of bit lines; characterized by

first and second shunt means, said first and second shunt means respectively contected across said word line and drain line of said first word-drain line pair and said word line and drain line of said second word-drain line pair, said first and second shunt means respectively limiting word line to drain line voltage and also controlling the saturation of at least certain transistors employed in said CTS type cells.

2. Integrated random access read/write memory, as recited in claim 1, wherein each of said complementary transistor current switch (CTS) type memory cells characterized by

first and second PNP transistors, said first and second PNP transistors (T1 and T2) each having an emitter, base and collector, said emitters of said first and second PNP transistors being respectively connected to a predetermined one of said word lines;

first and second NPN transistors, said first and second NPN transistors each having an emitter, base and collector, said base of said first NPN transistor being connected in common to said collector of said first PNP transistor, said collector of said second NPN transistor and said base of said second PNP transistor, said base of said second NPN transistor being connected in common to said collector of said second PNP transistors, said collector of said first NPN transistor and said base of said first PNP transistor, said emitters of said first and second NPN transistors being respectively connected to a predetermined one of said drain lines;

a first diode (D1) connected between said base of said first PNP transistor and a predetermined one of said left bit lines; and

a second diode (D2) connected between said base of said second PNP transistor and a predetermined one of said right bit lines.

3. Integrated random access read/write memory as recited in claim 2, wherein said first and second diodes (D1 and D2) are respectively Schottky diodes.

4. Random access memory, as recited in claims 1 - 3, characterized that the first shunt means and the second shunt means are respectively a PN diode.

5. Random access memory, as recited in claims 1 - 4, characterized by

an array of memory cells having m columns and n rows, where m and n are positive integers and said memory array includes m x n memory cells, where each of said cells has the capacity to store one binary bit;

m pairs of bit lines, each pair of bit lines including a first bit line and a second bit line;

n pairs of word-drain lines, each pair of word-drain lines including a word line and a drain line;

each of said m columns of memory cells being connected between the first bit line and the second bit line of a discrete one of said m pairs of bit lines;

each of said n rows of memory cells being connected between the word line and drain line of a discrete one of said n pairs of word-drain lines;

controllable read/write address decoder circuit means for reading the binary bit ("0" or "1") stored in any predetermined one of said m x n array of memory cells, or writing a binary bit ("0" or "1") in any predetermined one said m x n array of memory cells; and

n identical write enhancement circuit means for enhancing the operation of said random access read/write memory array, each of said n identical write enhancement circuit means being a two-terminal device and each of said n identical circuit means being connected between the word line and the drain of a discrete one of said n pairs of word-drain lines.

6. Random access memory, as recited in claim 5, characterized by a modified complementary transistor switch (CTS) cell comprises,

first and second transistors of a first conductivity type, said first and second transistors each having an emitter, base and collector, said emitters of said first and second transistors respectively connected to the drain line of said discrete one of said n pairs of word-drain lines,

third and fourth transistors of a second conductivity type, said third and fourth transistors each having an emitter, base and collector, said emitter of said third transistor and said emitter of said fourth transistor being respectively connected to said word line of said discrete one of said n pairs of word-drain lines, said collector of said third transistor connected to said base of said first transistor, said base of said third transistor connected in common to said collector of said first transistor and said base of said second transistor, said collector of said fourth transistor connected to said base of said second transistor, said base of said fourth transistor connected in common to said collector of said second transistor and said base of said first transistor, and

first and second diodes, said first diode connected between said base of said third transistor and the first bit line of said discrete one of said m pairs of bit lines, and said second diode connected between said base of said fourth transistor and said second bit line of said discrete one of said m pairs

of bit lines.

COMPLEMENTARY TRANSISTOR SWITCH
(CTS) MEMORY CELL

FIG. 1 PRIOR ART

FIG. 2

- FI 983 052

N-EPI   C     N+EMITTER     N+EMITTER

E   P+BASE  A   ROI   B   N+RT  D  N-EPI PYRO

NITRIDE

OXIDE

ROI                                            ROI

N++SUBCOLLECTOR

P- SUBSTRATE

P+ISOLATION                           P+ISOLATION

## FIG. 3A

C     E     A     B     D

## FIG. 3B

A   T1

D1

D            B

C

T2

E

## FIG. 4

BIT DECODER 1

WRITE PULSE

WRITE ENABLE

WRITE 0+    WRITE 1+

WRITE CIRCUIT 1

WORD DECODE

WORD LINE TO
DRAIN LINE
SHUNT

LEFT BIT 1    RIGHT BIT 1

FIG. 5A

FIG. 5 | FIG. 5A | FIG. 5B

FIG. 5

SENSE AMPLIFIER / LATCH

SR

BIT DECODER m

WRITE 0   WRITE 1

WRITE CIRCUIT m

WRITE ENABLE

WORD LINE 1

DRAIN LINE 1

LEFT BIT m    RIGHT BIT m

WORD LINE n

DRAIN LINE n

FIG. 5B

- F1 983 052

WORD LINE

D1   T1                    T3

LEFT
BIT
RAIL                              RIGHT
                                  BIT
                                  RAIL
                            D3

T2                          T4

DRAIN LINE

## FIG. 6

WORD LINE

$V_{WRITE}$        D1   T1              T3        $V_1$

$V_0$                                        D3    $V_0$

LEFT                                      RIGHT
BIT                                        BIT
RAIL                                      RAIL

T2                                    T4

DRAIN LINE

## FIG. 7

**FIG. 5C**

WORD LINE

DRAIN LINE

BIT LINES

WRITE PAUSE

2  4  6  8  10  12  14  16  18  20  22  24

TIME

SELECTION | READ | WRITE | END OF | DESELECTION
WRITE

LEFT BIT LINE

NBL

WORD LINE NWL

RIGHT BIT LINE

NBR

−VJDIF+

DRAIN LINE NDL

UNCLAMPED CTS CELL

SHUNT THAT LIMITS
WORD TO DRAIN (VJWD)
VOLTAGE AND CONTROLS
THE NPN TX'S SATURATION

UNCLAMPED CTS
USING A WORD TO DRAIN LINE SHUNT

**FIG. 8**

WITHOUT SHUNT IT TAKES ABOUT 16ns
TO WRITE NEW DATA IN THE CELL.

WORD TO DRAIN LINE VOLTAGE (VJWD)
WORD LINE VOLTAGE (NWL)
RIGHT HAND BIT LINE VOLTAGE (NBR)
LEFT HAND BIT LINE VOLTAGE (NBL)

CELL DIFFERENCE VOLTAGE
(VJDIF)

DRAIN LINE
VOLTAGE (NDL)

VOLTS

WRITE TIME
16ns

TIME (NANOSECONDS)

NWL ——————
NDL —·—·—·—·—
NBR ——————
NBL ——————
VJWD ············
VJDIF. CELL ——————

FIG. 9

WITH SHUNT IT TAKES ABOUT 2ns TO WRITE
NEW DATA IN CELL.
NOTE HOW THE WORD LINE (NWL) AND
DRAIN LINE (NDL) REMAIN FAIRLY
CONSTANT AND THE WORD TO DRAIN
DIFFERENCE (VJWD) DOESN'T CHANGE AT ALL

VOLTS

WRITE TIME
2ns

TIME (NANOSECONDS)

NWL ————————
NDL —·—·—·—·—
NBR ————————
NBL —— —— —— ——
VJWD ·············
VJ DIF. CELL ————————

FIG. 10